(19) Europäisches Patentamt
European Patent Office
Office européen des brevets

(11) **EP 2 287 983 A1**

(12) **EUROPEAN PATENT APPLICATION**

(43) Date of publication:
23.02.2011 Bulletin 2011/08

(51) Int Cl.:
*H01S 5/50* (2006.01)    *H01S 5/10* (2006.01)
*H01S 5/20* (2006.01)    *H01S 5/227* (2006.01)

(21) Application number: 09162795.0

(22) Date of filing: 17.08.2009

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(71) Applicant: Danmarks Tekniske Universitet - DTU
2800 Kongens Lyngby (DK)

(72) Inventor: Yvind, Kresten
1669 Copenhagen V (DK)

(74) Representative: Kitchen, Steven Richard et al
Chas. Hude A/S
H.C. Andersens Boulevard 33
1780 Copenhagen V (DK)

(54) **Broadband travelling wave semiconductor optical amplifier**

(57) Broadband travelling wave semiconductor optical amplifier (100, 200, 300, 400) for amplification of light, wherein the amplifier (100, 200, 300, 400) comprises a waveguide region (101, 201, 301, 401) for providing confinement of the light in transverse directions and adapted for propagation of the light in at least a first mode along a longitudinal axis (102, 202, 302) of the amplifier (100, 200, 300, 400) in a propagation direction (103, 203, 303), and wherein the waveguide region (101, 201, 301, 401) comprises a gain region (104, 204, 304, 404) for amplifying the light and an outer region (105, 205, 305, 405), the waveguide region (101, 201, 301, 401) having a width (106, 206, 306) and a height, and the gain region (104, 204, 304, 404) having a width (107, 207, 307) and a height, wherein the width (106, 206, 306) of the waveguide region (101, 201, 301, 401) increases along the longitudinal axis (102, 202, 302), and wherein the ratio between the width (106, 206, 306) of the waveguide region (101, 201, 301, 401) and the width (107, 207, 307) of the gain region (104, 204, 304, 404) increases along the longitudinal axis (102, 202, 302).

Fig. 1

EP 2 287 983 A1

**Description**

The present invention relates to a broadband travelling wave semiconductor optical amplifier for amplification of light, wherein the amplifier comprises a waveguide region for providing confinement of the light in transverse directions, and said waveguide region being adapted for propagation of the light in at least a first mode along a longitudinal axis of the amplifier in a propagation direction, and wherein the waveguide region comprises a gain region for amplifying the light, the waveguide region having a width and a height, and the gain region having a width and a height. The invention also relates to a method for amplification of broadband light in an optical amplifier.

It is an object of the present invention to obtain a new broadband travelling wave semiconductor optical amplifier, and a new method for amplification of broadband light in an optical amplifier, which overcome or ameliorate at least one of the disadvantages of the prior art or which provide a useful alternative.

The object is achieved by a broadband travelling wave semiconductor optical amplifier for amplification of light, wherein the amplifier comprises a waveguide region for providing confinement of the light in transverse directions, and said waveguide region being adapted for propagation of the light in at least a first mode along a longitudinal axis of the amplifier in a propagation direction, and wherein the waveguide region comprises a gain region for amplifying the light and an outer region, the waveguide region having a width and a height, and the gain region having a width and a height, wherein the width of the waveguide region increases along the longitudinal axis, and wherein the ratio between the width of the waveguide region and the width of the gain region increases along the longitudinal axis. By increasing the width of the waveguide region, the light beam is expanded while it is being amplified. Thus, the peak intensity of the light in the amplifier may be lowered, compared to an unexpanded beam, and thereby lowers the saturation. In this way, detrimental effects related to high peak powers, such as saturation of the amplifier, and saturation by amplified spontaneous emission (ASE), may be countered. The saturation is wavelength dependent and will therefore lower the optical bandwidth of the device. To allow the light beam to expand independently of the width of the gain region, it is important that the gain region does not guide the light significantly.

According to a broader aspect of the invention, the amplifier may not have a waveguiding region, but merely rely on the light beam diverging by diffraction, e.g. according to the well-known properties of a Gaussian beam. In this case, the width of the gain region may advantageously be selected to provide a gain that matches the decrement in peak intensity provided by the beam expansion.

In a particular embodiment of the invention, the height of the gain region and the height of the waveguide region are both substantially constant throughout the device. This yields for a particularly convenient manufacturing of the amplifier, since a uniform deposition rate may be applied across the whole device, or indeed over a full wafer of devices.

In an embodiment of the invention, the width of the waveguide region increases in the propagation direction in such a way so as to decrease a peak intensity of the light at a rate corresponding to an increase in peak intensity provided by the gain region. By this balancing of the increase in peak intensity caused by the applied gain, and the decrease in peak intensity caused by the expansion of the beam, an amplifier may be constructed to have a suitable device gain, while the peak intensity remains substantially constant throughout the device.

According to a specific embodiment of the invention, the waveguide region is adapted for providing an intensity distribution of light having a $1/e^2$ halfwidth $w_b$ that adheres substantially to the equation:

$$\frac{\mathrm{d}\,w_b(z)}{\mathrm{d}\,z} = w_b(z)\left(-\alpha_0 + (\Gamma g_0 + \alpha_0)\mathrm{erf}\left(\frac{w_g(z)}{\sqrt{2}w_b(z)}\right)\right),$$

where z is the position in the longitudinal direction, $w_g$ is the width of the gain region, $\alpha_0$ is the waveguide loss outside the gain region, $\Gamma g_0$ is the modal gain, and erf is the error function. By arranging the waveguide region to have a width that satisfies the above equation, the peak intensity of the travelling light is constant, assuming that the propagation is linear. Evidently to the skilled person, minor variations from the strict mathematical solution may be envisioned, e.g. due to fabrication issues, without thus deviating from the scope of the invention.

In another embodiment of the invention, the width of the waveguide region $w_w$ adheres substantially to the equation:

$$\frac{\mathrm{d}\,w_w(z)}{\mathrm{d}\,z} = w_w(z)\left(-\alpha_0 + (\Gamma g_0 + \alpha_0)\mathrm{erf}\left(\frac{w_g(z)}{\sqrt{2}w_w(z)}\right)\right),$$

where z is the position in the longitudinal direction, $w_g$ is the width of the gain region, $\alpha_0$ is the waveguide loss outside the gain region, $\Gamma g_0$ is the modal gain, and erf is the error function. This embodiment is an approximation of the above-mentioned embodiment concerning the width of the intensity profile. By arranging the waveguide region to have a width that satisfies the above equation, the peak intensity of the travelling light is approximately constant, assuming that the propagation is linear. Evidently to the skilled person, minor variations from the strict mathematical solution may be envisioned, e.g. due to fabrication issues, without thus deviating from the scope of the invention.

In another embodiment of the invention, the gain region has a substantially constant width along the longitudinal axis. In this way, a uniform carrier density is achieved.

In an alternative embodiment, the width of the gain region decreases along the length of the device.

In an alternative embodiment, the width of the gain region increases along the length of the device.

In another embodiment of the invention, the gain region is adapted for providing a gain to light having a vacuum wavelength in the range 0.8μm-1.2μm, or 0.9μm-1.1μm, or even 1.0μm-1.1μm. Broadband amplifiers are particularly technologically challenging in these wavelength ranges, and are limited by gain saturation and saturation by amplified spontaneous emission. The independent flaring of the mode with respect to the gain lowers the intensity in the gain region and thereby the saturation. By suitable material selection, amplifiers according to the present invention may be readily adapted to work in these ranges.

In an alternative embodiment of the invention, the gain region is adapted for providing a gain to light having a vacuum wavelength in one or more subranges within the range 200 nm - 3μm. This may be achieved by a suitable material selection of e.g. GaN, InP and/or GaSb based materials.

In another embodiment of the invention, the gain region has a substantially constant width in the range 0.5-7μm, or 1-6μm, or even 2-5μm. To allow the light beam to expand independently of the width of the gain region, it is important that the gain region does not guide the light. This may be achieved by having a narrow gain region. On the other hand, if the gain region is too narrow, the device gain of the amplifier is lowered.

In another embodiment of the invention, the gain region comprises a quantum well material for providing gain. The advantage of a narrow quantum well is the the gain spectrum is intrinsic flat at high carrier densities. Examples could be InGaAs in AlGaAs or GaAs for applications around 1050nm. Combinations of quantum wells or dots at different energies may also be used to increase the intrinsic gain bandwidth of the gain material.

In another embodiment of the invention, the outer region of the waveguide region comprises intermixed quantum wells. This minimises the step in refractive index between the gain region and the waveguide region. A minimised index step ensures that the waveguide region and not the gain region provides guidance to the light and may enable the use of a wider gain region, resulting in a potentially increased device gain.

In another embodiment of the invention, the amplifier comprises from a top side: a top contact layer, a substrate comprising GaAs:Si, a top buffer layer comprising AlGaAs:Si, an active layer comprising a quantum well material, a bottom buffer layer comprising AlGaAs:C, an insulating layer, and a bottom contact layer. This embodiment is particularly advantageous, as it may be mounted with a p-side down, to aid thermal control of the amplifier device. Furthermore, the intermixed quantum wells have the advantages stated for the above-mentioned embodiment.

The object of the invention is also obtained by a method for amplification of broadband light in an optical amplifier by propagating light to be amplified in a waveguide region in the optical amplifier, the waveguide region comprising a gain region, the method comprising the steps of:

a) providing gain to the light in the gain region to increase a peak intensity of the light, while
b) expanding the light in at least one transverse direction as the light propagates, by increasing a width of the waveguide region, to decrease the peak intensity of the light.

Amplification of light according to this method is advantageous, as a high gain may be achieved, while avoiding or limiting the detrimental effect caused by high peak intensities of light within the amplifier. In particular, amplifier saturation by the signal or by amplified spontaneous emission may be countered by the proposed method.

In an embodiment of the method according to the invention, the increase of peak intensity provided by step a) is substantially balanced by the decrease of peak intensity provided by step b) as light is propagated in the waveguide region. A constant or near constant peak intensity of light throughout the amplifier may be achieved in this way. This minimizes the detrimental effects of high peak intensities, as stated above.

The invention is explained in detail below with reference to an embodiment shown in the drawings, in which

Fig. 1 is a schematic top view of an embodiment according to the invention,

Fig. 2 is a schematic top view of another embodiment according to the invention,

Fig. 3 is a schematic top view of a third embodiment according to the invention,

Fig. 4 is a cross-sectional view of an embodiment of the invention,

Fig. 5 shows calculated results with varying modal gain according to an example,

Fig. 6 shows calculated results with varying loss in the outer region of the waveguide region, according to an example, and

Fig. 7 shows calculated results with varying width of the waveguide region at the amplifier input, according to an example.

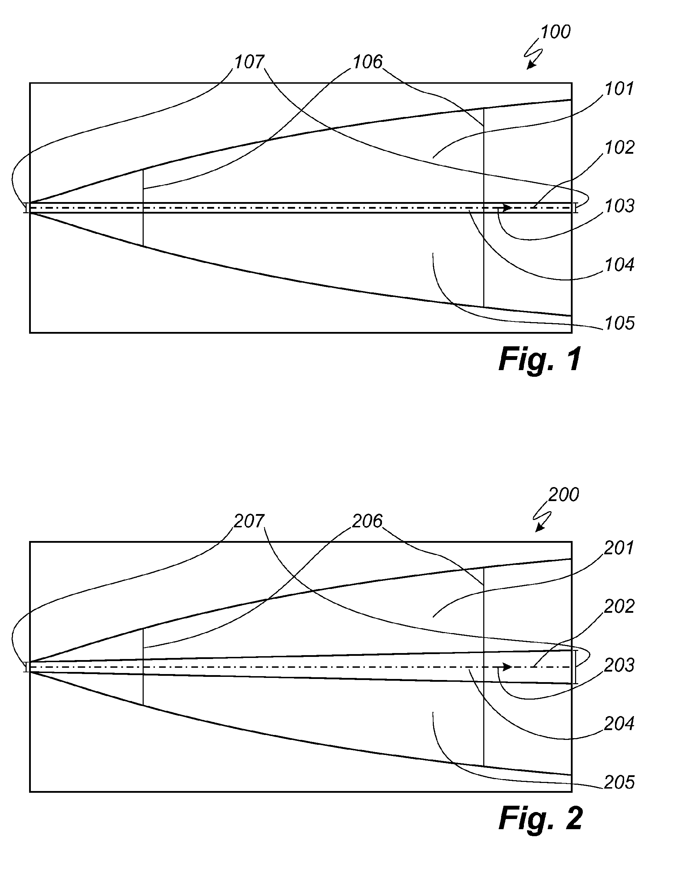

Fig. 1-3 show schematic top views of embodiments of amplifiers according to the invention, where similar reference numerals refer to similar parts. Therefore, only the differences between the three embodiments will be discussed here. Referring to Fig. 1, the amplifier 100 is shown to comprise a waveguide region 101. The waveguide region 101 provides guidance and confinement to the light in at least the transverse direction by the well-known principle of total internal reflection. Guidance out of the plane of the figure may also be provided by total internal reflection, or by any other suitable means, such as gain guidance. The waveguide region has a longitudinal axis 102, along which the propagating direction of the light 103 is. Inside the waveguide region 101, a gain region 104 is comprised. The gain region 104 is adapted to provide gain to the light in the amplifier. Care must be taken to prevent the gain region 104 from providing guidance to the propagating light, e.g. by matching the refractive index of the gain region 104 to the refractive index of the outside region 105 of the waveguide region 101, or by making the gain region 104 narrow, compared to the wavelength of the light. The waveguide region 101 has a width $w_b$ 106, and the gain region 104 has a width $w_g$ 107, the waveguide region width 106 generally being larger than the gain region width 107. The waveguide region width 106 increases along the longitudinal axis 102 in the propagating direction 103, both in absolute numbers and relatively to gain region width 107. Since the beam width of the propagating light increases along with the waveguide region width 106, the peak intensity of the light beam, corresponding to a fixed power level, is decreased. On the other hand, the amplification provided by the gain region increases the power level, and thus the peak intensity.

In the embodiment shown in Fig. 1, the gain region width 107 is substantially constant throughout the length of the amplifier 100. As the waveguide region width 106 increases, gain is applied to a progressively smaller part of the light beam, resulting in a decreasing differential gain with propagation length.

Fig. 2 shows a schematic top view of an embodiment, corresponding to the amplifier shown in Fig. 1, where similar reference numerals refer to similar parts. Therefore, only the differences between the two embodiments are discussed here. In the present embodiment, both the waveguide region width 206 and the gain region width 207 increase in the propagating direction 203, along the longitudinal axis 202.

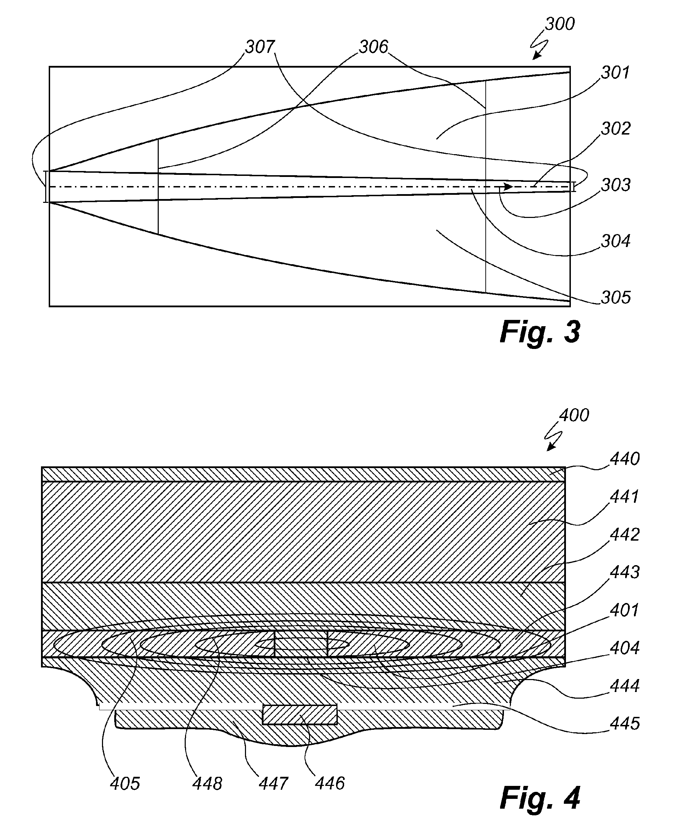

Fig. 3 shows a schematic top view of an embodiment, corresponding to the amplifier shown in Fig. 1 and Fig. 2, where similar reference numerals refer to similar parts. Therefore, only the differences between the two embodiments are discussed here. In the present embodiment, the waveguide region width 306 increases, while the gain region width 307 increases in the propagating direction 303, along the longitudinal axis 302.

Fig. 4 illustrates a cross-sectional view of an advantageous embodiment of an amplifier 400 according to the invention. A GaAs:Si substrate 441 is provided with a contact layer 440 of e.g. nickel, germanium, gold on one side. On the other side, a top buffer layer 442 comprising AlGaAs:Si is deposited, e.g by organometallic vapour phase epitaxy. Then an active layer 443, comprising the gain region 404 and the waveguide region 401 is deposited. The gain region 404 comprises a quantum well material, such as 6nm $In_{0.35}Ga_{0.65}As$ for providing gain to the propagating light. In the outer region 405 of the waveguide region, intermixed quantum wells are included to enable suppression of loss or gain in this region 405. Below the active layer 443 is a bottom buffer layer 444 comprising AlGaAs:C. An insulating layer 445, e.g. formed by thermal oxidation is included to help define the electrical field applied over the device between the top contact layer 440 and the bottom contact layer 447. Implantation may be used to further confine the current to the gain stripe. Also shown in the figure is a field distribution 448 of guided light.

Example:

A number of calculations have been made on an embodiment of the amplifier, while varying a number of parameters. In all cases, the $1/e^2$ halfwidth of the intensity profile of the light and the device gain have been calculated as a function of device length. Unless otherwise stated, the following parameters are assumed:

$$\alpha_0 = 3 \text{ cm}^{-1}, w_g = 2 \text{ μm}, w_{b,0} = 1 \text{ μm}, \Gamma g_0 = 50 \text{ cm}^{-1},$$

where $\alpha_0$ is the attenuation in the outer region of the waveguide region, $w_g$ is the width of the gain region, $w_{b,0}$ is the width of the intensity profile at the input end, and $\Gamma g_0$ is the modal gain. The intensity profile width is calculated from this equation:

$$\frac{\mathrm{d}\,w_b(z)}{\mathrm{d}\,z} = w_b(z)\left(-\alpha_0 + (\Gamma g_0 + \alpha_0)\mathrm{erf}\left(\frac{w_g(z)}{\sqrt{2}w_b(z)}\right)\right),$$

which assumes linear propagation. Furthermore, the light beam is assumed to be Gaussian.

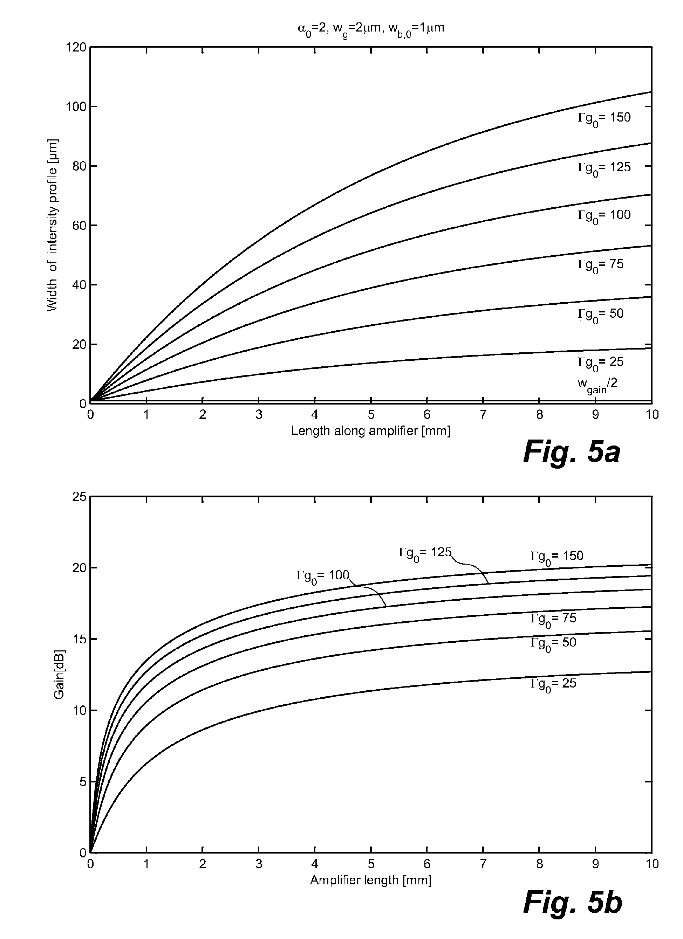

Fig. 5 shows the results of calculations, where the modal gain $\Gamma g_0$ has been varied from 25cm$^{-1}$ to 150cm$^{-1}$, other parameters are as stated above. It is seen in Fig. 5a that the larger the modal gain is, the wider the intensity profile must be. However, as seen in Fig. 5b, the larger the modal gain, the larger the device gain. Furthermore, it is seen that it is possible to obtain a compact device with a high gain according to the invention. In comparison, a Gaussian beam with a beam waist of 1$\mu$m and a wavelength of 1$\mu$m would have diverged to a beam width of 3.3mm after propagating 10mm. Thus, the increase in intensity profile width is much slower than a freely diverging beam.

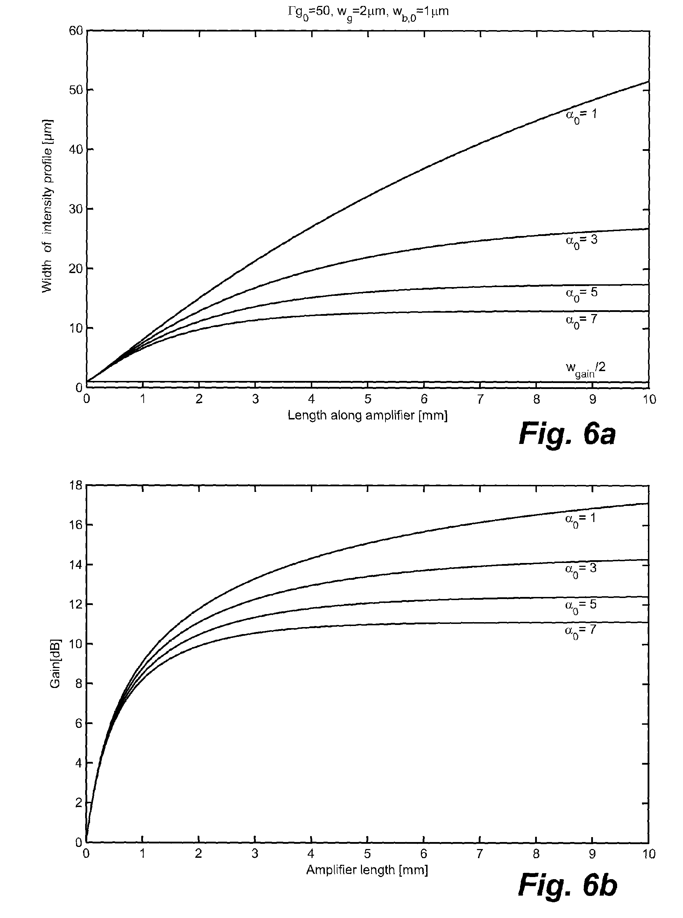

In Fig. 6 results of corresponding calculations are shown, where the attenuation in the outer region of the waveguide region has been varied in the range from 1cm$^{-1}$ to 7cm$^{-1}$. Evidently, a large attenuation in the outer region decreases the maximum device gain. Also, with a large attenuation, the optimum width of intensity profile is decreased, i.e. the gain region occupies a larger fraction of the waveguide region than for a smaller attenuation.

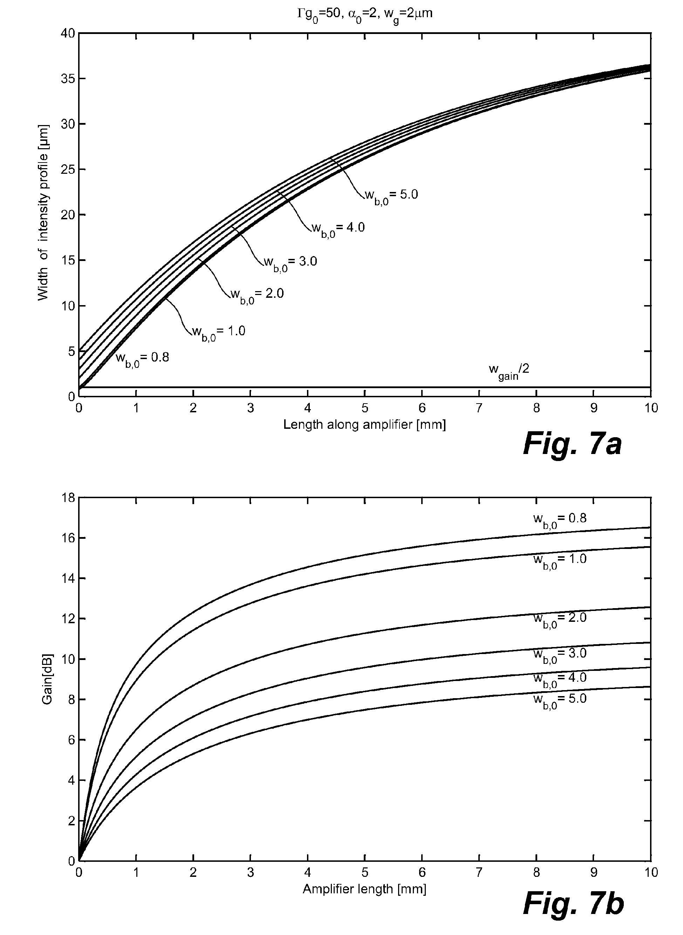

In Fig. 7, the width of the intensity profile at the amplifier input is varied. Only minor differences are seen to be optimal in the waveguide region width at the output. However, the device gain shows a large dependence on the input width. This is due to the fact that a major part of the amplification occurs near the input end of the amplifier. Therefore, a large overlap between the light and the gain region in this region results in a large amplification and thus a large device gain.

The examples have been described according to preferred embodiments of the invention. However, the invention is not limited to these embodiments. For example, the outer region is here described to comprise intermixed quantum wells for minimizing the step in refractive index between the gain region and outer region. However, an alternative embodiment may comprise epitaxial regrowth to define the gain stripe and index difference between the passive and active areas of the device. Also, the invention is here described to provide gain for light with a wavelength around 1$\mu$m. However, other material systems are also envisioned for providing gain at other wavelengths.

Reference numeral list:

| | |
|---|---|
| 100, 200, 300, 400 | amplifier |
| 101, 201, 301, 401 | waveguide region |
| 102, 202, 302 | longitudinal axis |
| 103, 203, 303 | propagation direction |
| 104, 204, 304, 404 | gain region |
| 105, 205, 305, 405 | outer region |
| 106, 206, 306 | waveguide region width, $w_w$ |
| 107, 207, 307 | gain region width, $w_g$ |
| 440 | top contact layer |
| 441 | substrate |
| 442 | top buffer layer |
| 443 | active layer |
| 444 | bottom buffer layer |
| 445 | insulating layer |
| 446 | contact |
| 447 | bottom contact layer |
| 448 | field distribution |

**Claims**

1. Broadband travelling wave semiconductor optical amplifier (100, 200, 300, 400) for amplification of light, wherein the amplifier (100, 200, 300, 400) comprises a waveguide region (101, 201, 301, 401) for providing confinement of the light in transverse directions, and said waveguide region (101, 201, 301, 401) being adapted for propagation of the light in at least a first mode along a longitudinal axis (102, 202, 302) of the amplifier (100, 200, 300, 400) in a propagation direction (103, 203, 303), and wherein the waveguide region (101, 201, 301, 401) comprises a gain region (104, 204, 304, 404) for amplifying the light and an outer region (105, 205, 305, 405), the waveguide region (101, 201, 301, 401) having a width (106, 206, 306) and a height, and the gain region (104, 204, 304, 404) having a width (107, 207, 307) and a height, wherein the width (106, 206, 306) of the waveguide region (101, 201, 301, 401) increases along the longitudinal axis (102, 202, 302), and wherein the ratio between the width (106, 206, 306) of the waveguide region (101, 201, 301, 401) and the width (107, 207, 307) of the gain region (104, 204, 304, 404) increases along the longitudinal axis (102, 202, 302).

2. Amplifier (100, 200, 300, 400) according to claim 1, wherein the width (106, 206, 306) of the waveguide region (101, 201, 301, 401) increases in the propagation direction (103, 203, 303) in such a way so as to decrease a peak intensity of the light at a rate corresponding to an increase in peak intensity provided by the gain region (104, 204, 304, 404).

3. Amplifier (100, 200, 300, 400) according to claim 1 or 2, wherein the waveguide region (101, 201, 301, 401) is adapted for providing an intensity distribution of light having a $1/e^2$ halfwidth $w_b$ that adheres substantially to the equation:

$$\frac{\mathrm{d}\,w_b(z)}{\mathrm{d}\,z} = w_b(z)\left(-\alpha_0 + (\Gamma g_0 + \alpha_0)\mathrm{erf}\left(\frac{w_g(z)}{\sqrt{2}w_b(z)}\right)\right),$$

where z is the position in the longitudinal direction (103, 203, 303), $w_g$ is the width (107, 207, 307) of the gain region (104, 204, 304, 404), $\alpha_0$ is the waveguide loss outside the gain region (104, 204, 304, 404), $\Gamma g_0$ is the modal gain, and erf is the error function.

4. Amplifier (100, 200, 300, 400) according to claim 1 or 2, wherein the width (106, 206, 306) of the waveguide region $w_w$ (101, 201, 301, 401) adheres substantially to the equation:

$$\frac{\mathrm{d}\,w_w(z)}{\mathrm{d}\,z} = w_w(z)\left(-\alpha_0 + (\Gamma g_0 + \alpha_0)\mathrm{erf}\left(\frac{w_g(z)}{\sqrt{2}w_w(z)}\right)\right),$$

where z is the position in the longitudinal direction (103, 203, 303), $w_g$ is the width (107, 207, 307) of the gain region (104, 204, 304, 404), $\alpha_0$ is the waveguide loss outside the gain region (104, 204, 304, 404), $\Gamma g_0$ is the modal gain, and erf is the error function.

5. Amplifier (100, 200, 300, 400) according to any of the preceding claims, wherein the gain region (104, 204, 304, 404) has a substantially constant width (107, 207, 307) along the longitudinal axis (102, 202, 302).

6. Amplifier (100, 200, 300, 400) according to any of the preceding claims, wherein the gain region (104, 204, 304, 404) is adapted for providing a gain to light having a vacuum wavelength in the range 0.8μm-1.2μm, or 0.9μm-1.1μm, or even 1.0μm-1.1μm.

7. Amplifier (100, 200, 300, 400) according to any of the preceding claims, wherein the gain region (104, 204, 304, 404) has a substantially constant width (107, 207, 307) in the range 0.5-7μm, or 1-6μm, or even 2-5μm.

8. Amplifier (100, 200, 300, 400) according to any of the preceding claims, wherein the gain region (104, 204, 304, 404) comprises a quantum well material for providing gain.

9. Amplifier (100, 200, 300, 400) according to any of the preceding claims, wherein the outer region of the waveguide region comprises intermixed quantum wells.

10. Amplifier (100, 200, 300, 400) according to any of the preceding claims, wherein the amplifier (100, 200, 300, 400) comprises from a top side: a top contact layer (440), a substrate (441) comprising GaAs:Si, a top buffer layer (442) comprising AlGaAs:Si, an active layer (443) comprising a quantum well material, a bottom buffer layer (444) comprising AlGaAs:C, an insulating layer (445), and a bottom contact layer (447).

11. Method for amplification of broadband light in an optical amplifier (100, 200, 300, 400), by propagating light to be amplified in a waveguide region (101, 201, 301, 401) in the optical amplifier (100, 200, 300, 400), the waveguide region (101, 201, 301, 401) comprising a gain region (104, 204, 304, 404), the method comprising the steps of:

   a) providing gain to the light in the gain region (104, 204, 304, 404) to increase a peak intensity of the light, while
   b) expanding the light in at least one transverse direction as the light propagates, by increasing a width (106, 206, 306) of the waveguide region (101, 201, 301, 401), to decrease the peak intensity of the light.

12. Method according to claim 11, wherein the increase of peak intensity provided by step a) is substantially balanced by the decrease of peak intensity provided by step b) as light is propagated in the waveguide region (101, 201, 301, 401).

*Fig. 1*

*Fig. 2*

**Fig. 3**

**Fig. 4**

Fig. 5a

Fig. 5b

$\Gamma g_0 = 50$, $w_g = 2\mu m$, $w_{b,0} = 1\mu m$

**Fig. 6a**

**Fig. 6b**

*Fig. 7a*

*Fig. 7b*

Europäisches
Patentamt
European
Patent Office
Office européen
des brevets

**EUROPEAN SEARCH REPORT**

Application Number

EP 09 16 2795

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EMERY J-Y ET AL: "High performance 1.55 [micro]m polarisation-insensitive semiconductor optical amplifier based on low-tensile-strained bulk GaInAsP" ELECTRONICS LETTERS, IEE STEVENAGE, GB, vol. 33, no. 12, 5 June 1997 (1997-06-05), pages 1083-1084, XP006007562 ISSN: 0013-5194 | 1-2 | INV. H01S5/50 ADD. H01S5/10 H01S5/20 H01S5/227 |
| A | * column 1 - column 2; figure 1 * ----- | 3-12 | |
| A | US 5 539 571 A (WELCH DAVID F [US] ET AL) 23 July 1996 (1996-07-23) * column 6, line 62 - column 8, line 8; figures 1,7 * ----- | 1-12 | |
| A | US 4 713 821 A (BRADFORD JAMES N [US] ET AL) 15 December 1987 (1987-12-15) * column 3, paragraph 25 - column 4, paragraph 20; figures 2,3 * ----- | 1-12 | |
| A | US 5 835 261 A (TAMANUKI TAKEMASA [JP] ET AL) 10 November 1998 (1998-11-10) * column 5, paragraph 10 - column 6, paragraph 32 * ----- | 1-12 | TECHNICAL FIELDS SEARCHED (IPC) H01S |

The present search report has been drawn up for all claims

| Place of search | Date of completion of the search | Examiner |
|---|---|---|
| Munich | 11 March 2010 | Hervé, Denis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 16 2795

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2010

| Patent document cited in search report | | Publication date | Patent family member(s) | | Publication date |
|---|---|---|---|---|---|
| US 5539571 | A | 23-07-1996 | NONE | | |
| US 4713821 | A | 15-12-1987 | NONE | | |
| US 5835261 | A | 10-11-1998 | JP | 2817769 B2 | 30-10-1998 |
| | | | JP | 8186330 A | 16-07-1996 |

EPO FORM P0459

For more details about this annex : see Official Journal of the European Patent Office, No. 12/82